# EUROPEAN PATENT SPECIFICATION

(11) **EP 1 593 342 B1**
(45) Date of publication and mention of the grant of the patent: **14.12.2011**
(21) Application number: 04709360.4
(22) Date of filing: 09.02.2004
(51) Int. Cl.: A61B 5/055, G01R 33/383, H01F 7/02

(54) **MAGNETIC FIELD-PRODUCING DEVICE**
MAGNETFELDPRODUZIERENDE VORRICHTUNG
DISPOSITIF PRODUISANT UN CHAMP MAGNETIQUE

(30) Priority: 10.02.2003 JP 2003032111
(43) Date of publication of application: 09.11.2005
(73) Proprietor: Hitachi Metals, Ltd., Minato-ku Tokyo (JP)
(72) Inventor: AOKI, Masaaki, Takatsuki-shi, Osaka 569-1044 (JP)
(74) Representative: Viering, Jentschura & Partner
(86) International application number: PCT/JP2004/001344
(87) International publication number: WO 2004/069052

(56) References cited:
- EP-A- 0 875 768
- EP-A- 0 921 408
- EP-A1- 0 618 457
- EP-A2- 0 399 789
- DE-A1- 19 709 297
- GB-A- 2 244 134
- JP-A- 4 371 136
- JP-A- 8 201 408
- JP-A- 8 294 261
- JP-A- 10 234 704
- JP-A- 60 257 109
- JP-A- 61 159 950
- JP-A- 61 159 950
- US-A- 5 016 638
- US-A- 5 614 880
- BUSH E D JR: "Permanent quadrupole magnets" 1976 PROTON LINEAR ACCELERATOR CONFERENCE ATOMIC ENERGY OF CANADA CHALK RIVER, ONT., CANADA, 1976, pages 363-368, XP008103569

## Description

### TECHNICAL FIELD

The present invention relates to a magnetic field generator, and more specifically to a permanent magnet type magnetic field generator used in an MRI (Magnetic Resonance Imaging) apparatus, an ESR imaging (Electron Spin Resonance Imaging) apparatus or an apparatus which serves as both.

### BACKGROUND ART

In order to take an MRI image and an ESR image simultaneously, two magnetic fields of different strengths are necessary. Generally, MRI requires a high magnetic field which has a strength not smaller than 0.2 T whereas ESR imaging requires a magnetic field whose strength is less than a half thereof (0.04 T for example). As an example of such an apparatus, JP-A 9-299347 proposes an apparatus which generates a magnetic field for an MRI and a magnetic field for an ESR imaging, with a single electric magnet. According to this method, the amount of electric current is varied in a single electric magnet, to switch between a resonance magnetic field strength for ESR imaging and a resonance magnetic field strength for MRI.

However, in order to generate a magnetic field as strong as 0.2 T with an electric magnet according to the method described above, a large power source apparatus is required. Further, a cooling apparatus and so on must be provided to deal with heat due to coil resistance. In addition, because of magnetic hysteresis which develops in magnetic components such as yokes when electric current is switched, it is difficult to increase magnetic field uniformity in both of the high magnetic field and the low magnetic field.

Further, when taking MRI images of a plurality of parts (such as the head and the feet) of an examinee (a test subject), imaging is made for a plurality of times in general. This has a practical reason that an MRI apparatus which can generate a very large magnetic field uniformity space capable of covering the entire body from the head to the feet would become too huge. However, recently, there are requirements for taking MRI images of a plurality of parts simultaneously for more precise diagnosis. Such a requirement could be met if two MRI apparatuses are placed side by side, but practically available MRI apparatuses are made not only of the magnetic circuit but also of a number of peripheral components. Simply placing two MRI apparatuses will not provide an effective magnetic circuit configuration while the entire apparatus would become impractically large. For these reasons, the dual-unit configuration described above is not adapted to date.

JP-61-159 950 A discloses an imaging arrangement including a pair of yokes arranged with a gap in between and two pairs of magnetic poles arranged so that the pairs of magnetic poles face each other between the yokes, and wherein there is a magnetic field uniformity space for the acquisition of an image.

US-5 614 880 and GB-2 244 134 A disclose an imaging apparatus including a double C-frame arrangement incorporating a superconducting magnet placed centrally between two beams which carry magnetic fields lines generated by the superconducting magnet. Two pairs of magnetic poles are situated at the ends of the beams and a uniformity space is arranged between each pair of magnetic poles for acquisition of an image. US-5 614 880 further discloses a quadruple C-frame arrangement, with the arms arranged to form a cross when viewed from above or below, capable of producing a plurality of homogeneous zones for imaging.

It is therefore a primary object of the present invention to provide a relatively small, magnetic field generator which has high magnetic efficiency and is capable of providing a high uniformity magnetic field at a plurality of locations.

### DISCLOSURE OF THE INVENTION

According to an aspect of the present invention as described in the claims, there is provided a permanent-magnet type magnetic field generator which has a plurality of magnetic field uniformity spaces.

The magnetic field generator according to the present invention is a permanent magnet type. Therefore, unlike those which use electric magnets, there is no need for operations to switch electric currents. By adjusting the magnetic fields generated in the plurality of magnetic field uniformity spaces in advance, a highly uniform magnetic field is obtained at a plurality of places in a single magnetic field generator, and it is possible to sustain the magnetic field uniformity and strength. Therefore, even when the magnetic field uniformity spaces generate different magnetic fields from each other, highly accurate magnetic field distribution is obtainable. Thus, it is possible to obtain e.g. an apparatus which serves as both high-quality MRI apparatus and ESR imaging apparatus, and an MRI apparatus which allows simultaneous MRI image taking of two or more parts.

The magnetic field generator includes: a pair of yokes faced to each other with a gap in between; and at least two pairs of magnetic poles. The poles in each pair are faced with each other between the pair of yokes, and the magnetic field uniformity space is formed between each pair of the magnetic poles. In this case, a plurality of pairs of magnetic poles are provided between a pair of yokes, and it is possible to form a plurality of magnetic field uniformity spaces between one pair of yokes. Therefore, magnetic efficiency can be improved over a case where a plurality of magnetic field generators are placed side by side, making possible to reduce the size of the apparatus.

Further preferably, the magnetic pole includes a pole piece. In this case, it is possible to improve uniformity of the magnetic field uniformity space.

Further, preferably, at least part of one yoke in the pair of yokes is movable toward and away from the other yoke. In this case, strength and uniformity of the magnetic field generated in the magnetic field uniformity space are adjustable as necessary.

Further, both a pair of the magnetic poles include a permanent magnet group formed by rare-earth magnets. In this case, it is possible to build a magnetic circuit which passes through such a pair of magnetic poles and the other pair of magnetic poles. Therefore, even if the other pair of magnetic poles does not include permanent magnet groups, it is possible to form a magnetic field uniformity space between that pair of magnetic poles. Further, it becomes possible to reduce a total amount of permanent magnet used for the construction, and thereby to reduce the weight of magnetic field generator.

Further, two magnetic field uniformity spaces which are adjacent to each other have different magnetic field strengths from each other as necessary. This enables to obtain a magnetic field generator suitable for an apparatus which serves as both MRI apparatus and ESR imaging apparatus for example.

Further, preferably, two magnetic field uniformity spaces which are adjacent to each other have their magnetic field directions differing from each other by 180 degrees. In this case, it is possible to build a magnetic circuit without supporting yokes such as a back yoke. Therefore, it becomes possible to reduce the weight of the magnetic field generator. Further, it becomes possible to reduce psychological pressure on the examinee.

Two pairs of magnetic poles are provided between the pair of yokes. With this construction, one of the pairs of magnetic poles includes a permanent magnet group provided by rare-earth magnets whereas the other pair of magnetic poles includes a padding member and a permanent magnet group provided by rare-earth magnets which are disposed on a main surface of the padding member. By using a padding member as described, it becomes possible to differentiate magnetic field strengths in the two magnetic fields generated by respective pairs of magnetic poles, while keeping respective gap dimensions in the two pairs of magnetic poles identical with each other even if both pairs of magnetic poles include permanent magnet groups which are made of rare-earth magnets. Therefore, in this case again, a magnetic field generator suitable for an apparatus which serves as both MRI apparatus and ESR imaging apparatus is obtained.

Further, preferably, electromagnetic shielding means is provided between two magnetic field uniformity spaces which are adjacent to each other. This eliminates interference by noises due to signal generation etc. in each of the magnetic field uniformity spaces, and improves the quality of obtained image. Further, it becomes possible to reduce the distance between mutually adjacent magnetic field uniformity spaces, which enables further size reduction of the entire apparatus.

In the present invention, the term "magnetic pole" refers to a part for forming an N pole or an S pole based on magnetic fluxes generated by permanent magnets. The magnetic pole is provided on each of mutually opposed faces of a pair of yokes which form a gap in between.

Therefore, it is possible to form a projection integrally on a gap-facing surface of a yoke and form an N pole or S pole on a tip portion of the projection, without disposing a pole piece. Further, an N pole or S pole may be formed directly at a tip portion of a permanent magnet group, without disposing a pole piece. Many other variations may be made without being limited by those embodiments which will be described later.

### BRIEF DESCRIPTION OF THE DRAWINGS

Fig. 1 is a perspective view showing an embodiment of the present invention;
Fig. 2 is a front view showing the embodiment in Fig. 1;
Fig. 3 is an illustrative diagram for describing MRI imaging according to the embodiment in Fig. 1;
Fig. 4 is an illustrative diagram for describing ESR imaging according to the embodiment in Fig. 1;
Fig. 5 is an illustrative diagram for describing MRI imaging at two positions according to the embodiment in Fig. 1;
Fig. 6 is a perspective view showing another embodiment of the present invention;
Fig. 7 is a perspective view showing another embodiment of the present invention;
Fig. 8 is a perspective view showing another embodiment of the present invention;
Fig. 9 is a perspective view showing another embodiment of the present invention;
Fig. 10 is a perspective view showing another embodiment of the present invention;
Fig. 11 is a perspective view showing another embodiment of the present invention;
Fig. 12 is a perspective view showing another embodiment of the present invention;
Fig. 13 is a perspective view showing another embodiment of the present invention;
Fig. 14 is a perspective view showing another embodiment of the present invention; and
Fig. 15 is a perspective view showing another embodiment of the present invention.

### BEST MODE FOR CARRYING OUT THE INVENTION

Hereinafter, an embodiment of the present invention will be described, with reference to the drawings.

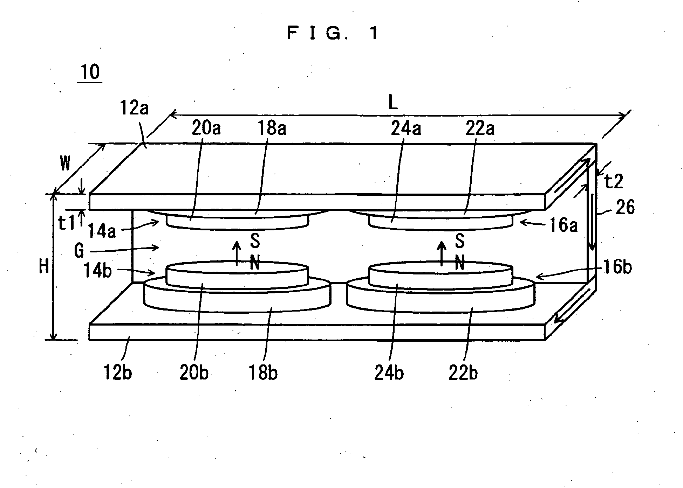

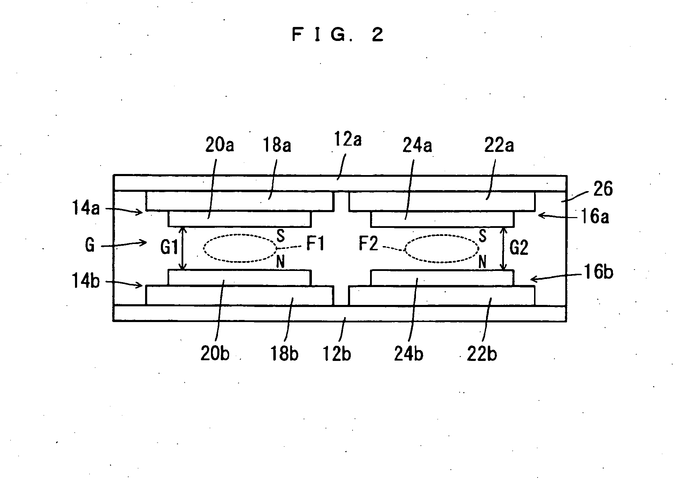

Referring to Fig. 1 and Fig. 2, a magnetic field generator 10 as an embodiment of the present invention is a permanent-magnet type magnetic field generator, and includes a pair of plate yokes 12a and 12b which are faced to each other to provide a gap G in between.

Between the pair of plate yokes 12a, 12b are two pairs of magnetic poles, i.e. a pair of magnetic poles 14a, 14b which are faced to each other, and another pair of magnetic poles 16a, 16b which are faced to each other.

The magnetic poles 14a, 14b include permanent magnet groups 18a, 18b respectively, which are disposed on the mutually opposed faces of the pair of plate yokes 12a, 12b. The permanent magnet groups 18a, 18b have their respective opposing faces provided with pole pieces 20a, 20b fixed thereon. Likewise, the magnetic poles 16a, 16b include permanent magnet groups 22a, 22b respectively, which are disposed on the mutually opposed faces of the pair of plate yokes 12a, 12b, and the permanent magnet groups 22a, 22b have their respective opposing faces provided with pole pieces 24a, 24b fixed thereon.

In the present embodiment, the magnetic poles 14a and 16a have the same polarity (S pole) and the magnetic poles 14b and 16b have the same polarity (N pole). This construction generates magnetic fields in the same direction (in an upward direction in the present embodiment as indicated by the arrows) between the magnetic poles 14a, 14b and between the magnetic poles 16a, 16b.

The permanent magnet groups 18a, 18b are made of rare-earth magnets or ferrite magnets for example, and built by piling magnet blocks into three tiers. The blocks are, for example, cubic with a side of 50 mm. The same construction is used for the permanent magnet groups 22a and 22b.

The pole piece 20a includes a disc-like base plate made of iron for example, which is disposed on a main surface of the permanent magnet group 18a. The base plate has a main surface provided with a silicon steel plate for prevention of eddy current from developing. The silicon steel plate has a laminate construction made of a plurality of block-like units and is fixed onto the base plate with an adhesive. The base plate has its circumference region formed with a circular projection which is made of iron for example, for increased magnetic field strength at the circumferential region and improved magnetic field uniformity. Formation of the circular projection creates an inner recess, where a gradient magnetic field coil is disposed. The same arrangement is made for the pole pieces 20b, 24a and 24b.

The plate yokes 12a and 12b are magnetically connected with each other by a supporting yoke (back yoke) 26 which is attached to respective rear ends of the plate yokes 12a and 12b.

In the magnetic field generator 10, a magnetic field uniformity space F1 is formed between the pair of pole pieces 20a, 20b and a magnetic field uniformity space F2 is formed between the pair of pole pieces 24a, 24b. Thus, two magnetic field uniformity spaces F1, F2 are formed in the magnetic field generator 10.

Here, the "magnetic field uniformity space" refers to a magnetic space formed between a pair of mutually opposed pole pieces in which magnetic field uniformity variation is not greater than 100 ppm. The term "center magnetic field strength" refers to a magnetic field strength at a center region of a magnetic field uniformity space.

The magnetic field generator 10 has, for example, a length L = 2000 mm, a width W = 1000 mm, a height H = 1026 mm, a thickness t1 of the plate yokes 12a, 12b = 150 mm, a thickness t2 of the supporting yoke 26 = 150mm, the gap G1 between the pole pieces 20a, 20b = 380 mm, and a gap G2 between the pole pieces 24a, 24b = 380 mm. With these dimensional settings, each of 160mm DSV magnetic field uniformity spaces F1, F2, has a center magnetic field strength of 0.2215 T. The magnetic field generator 10 has a total weight of 8262 kg, including the permanent magnet groups which weigh 1228 kg, the pole pieces which weigh 614 kg, the plate yokes which weigh 4710 kg, and the supporting yoke which weighs 1710 kg.

Since the magnetic field generator 10 is a permanent magnet type, unlike those which use electric magnets, no operation for switching electric currents is required. By adjusting the magnetic fields generated in the two magnetic field uniformity spaces F1, F2 in advance, two highly uniform magnetic fields are obtained at two respective places in a single magnetic field generator 10, and it is possible to sustain the magnetic fields. Therefore, it is possible to obtain e.g. an apparatus which serves as both of a high-quality MRI apparatus and an ESR imaging apparatus, or an MRI apparatus which is capable of taking MRI images of two or more different parts simultaneously.

Further, unlike those which use electric magnets, there is no need for a large electric power source apparatus.

Further, since two pairs of magnetic poles are provided between a pair of plate yokes 12a, 12b, and it is possible to form two magnetic field uniformity spaces F1, F2, magnetic efficiency is higher than placing two magnetic field generators side by side. This enables to reduce the size of magnetic circuit itself, as well as to simplify peripheral components, and to make compact the entire apparatus.

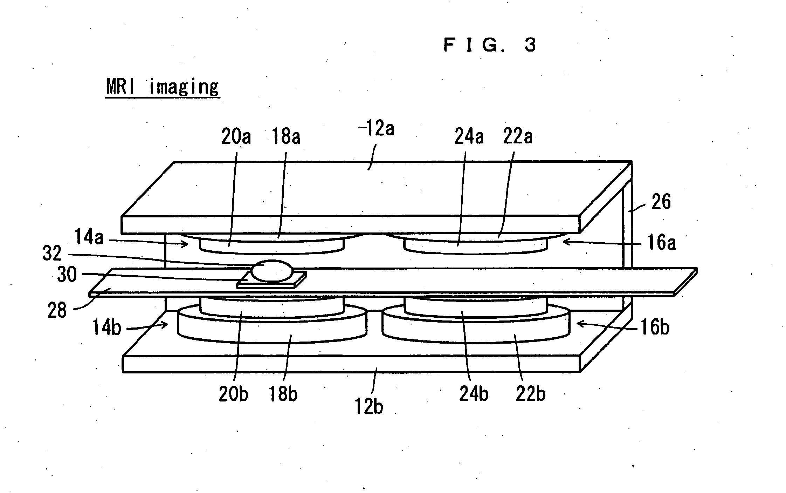

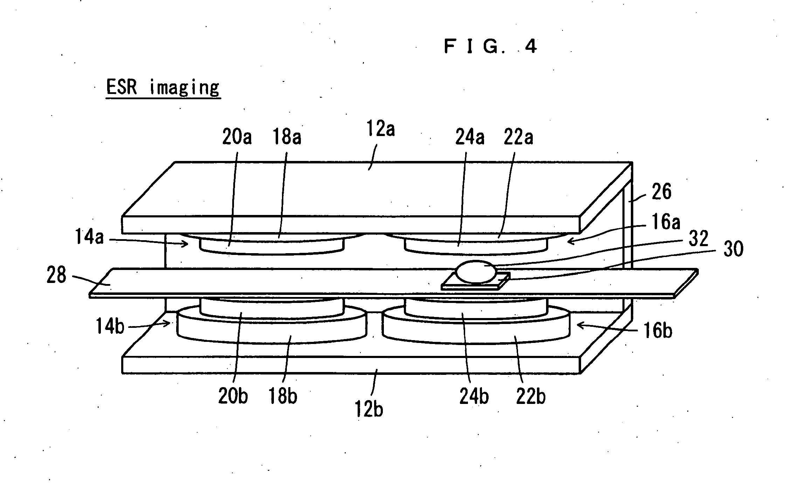

Description will cover a case where the magnetic field generator 10 is used for an apparatus that serves as both MRI apparatus and ESR imaging apparatus, with reference to Fig. 3 and Fig. 4.

A fixed table 28 is provided to pass through between the pair of magnetic poles 14a, 14b and between the pair of magnetic poles 16a, 16b. A movable table 30 is disposed on the fixed table 28. The movable table 30 is movable on the fixed table 28 longitudinally thereof, and on this movable table 30, a test subject 32 is placed. Moving means for the movable table 30 can be a linear motor or an electric cylinder for example. Further, use of position sensors such as Magnescale enables accurate positioning of the movable table 30 and the test subject 32. The side on the magnetic poles 14a, 14b is used for MRI image taking whereas the side on the magnetic poles 16a, 16b is used for ESR image taking.

First, when taking MRI images, as shown in Fig. 3, the test subject 32 is placed in the magnetic field uniformity space F1 between the pole pieces 20a, 20b, and then MRI images are taken. Quickly thereafter, the movable table 30 on which the test subject 32 is placed is moved so that the test subject 32 comes in the magnetic field uniformity space F2 between the pole pieces 24a, 24b as shown in Fig. 4, where ESR images are taken.

As described, by taking MRI and ESR images of the same test subject consecutively, it is possible to obtain different kinds of information about a single test subject. Therefore, MRI imaging can reveal information about the form in the test area, while ESR imaging can reveal chemical information such as locations where radical oxygen is present in the test area, for example. This increases the value of image diagnosis, making the information available for e.g. biopsy of the most malign area of a tumor of a patient, accurate determination of the area to treat, and planning of medical operations.

In the above embodiment, the test subject 32 is moved when image taking operation is changed from MRI to ESR. Alternatively, the apparatus (plate yokes 12a, 12b, supporting yoke 26, etc.) may be moved instead. In this case, there is no need to perform position adjustment of the test subject 32 since the test subject 32 is not moved and therefore the area to be examined stays lined up.

Generally, the magnetic field strength necessary for ESR image taking may be lower than the magnetic field strength necessary for MRI image taking. Thus, permanent magnets included in the magnetic poles for ESR image taking may be of a relatively weak magnetic force.

For example, in the pair of magnetic poles 14a, 14b, the permanent magnet groups 18a, 18b may be made of rare-earth magnets whereas in the other pair of the magnetic poles 16a, 16b, the permanent magnet groups 22a, 22b may be made of ferrite magnets. With such an arrangement, it becomes possible to differentiate magnetic field strengths in the two magnetic fields generated by respective pairs of magnetic poles, while keeping the two gaps G1 and G2 the same.

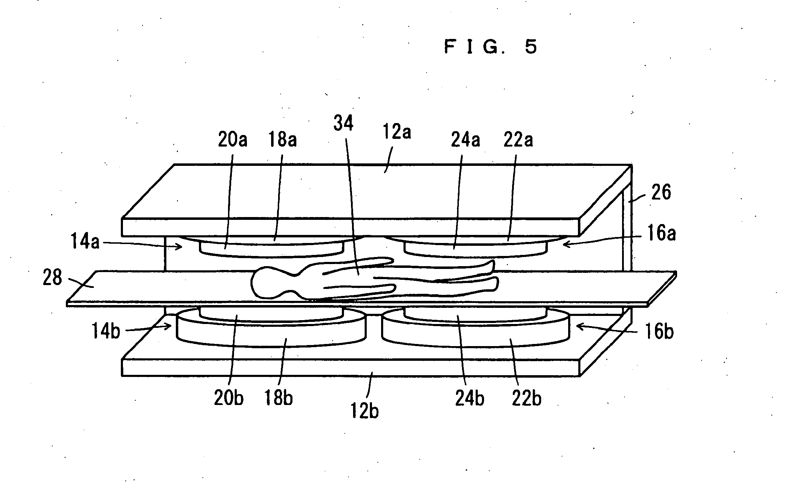

Next, description will be made for a case where the magnetic field generator 10 is used for an apparatus that allows MRI image taking at two locations. Reference will be made to Fig. 5

For example, when MRI image taking is made simultaneously to the head and feet of an examinee 34, the examinee 34 lays down on the fixed table 28, placing his head in the magnetic field uniformity space F1 between the pair of pole pieces 20a, 20b, and his feet in the magnetic field uniformity space F2 between the pair of pole pieces 24a, 24b. In this state, MRI images of the head and the feet of the examinee 34 are taken simultaneously.

As described, by taking MRI images of a plurality of parts of the examinee (the test subject) simultaneously, diagnosis can become efficient.

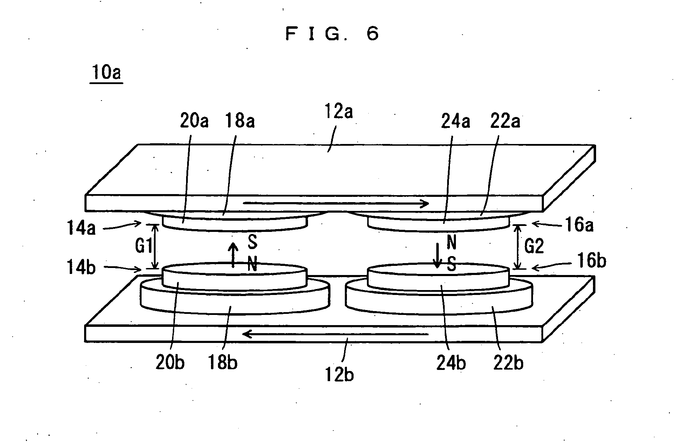

Next, reference will be made to Fig. 6 to describe a magnetic field generator 10a as another embodiment of the present invention.

In the magnetic field generator 10a, the magnetic poles 14a and 16a have opposing magnetic poles, and the magnetic poles 14b and 16b have opposing magnetic poles so that the direction of magnetic field generated between the pair of magnetic poles 14a, 14b and the direction of magnetic field generated between the pair of magnetic poles 16a, 16b are opposing to each other (differing from each other by 180 degrees). This eliminates the need for supporting yoke 26 at the back, and magnetic circuits indicated by the arrows are formed in the magnetic field generator 10a. The plate yoke 12a may be supported by being suspended from the ceiling for example

In the present embodiment, the direction of magnetic field generated in the magnetic field uniformity space F1 between the pair of pole pieces 20a, 20b and the direction of magnetic field generated in the magnetic field uniformity space F2 between the pair of pole pieces 24a, 24b are different by 180 degrees (opposing relationship), but it is possible to make their strength equal to each other.

For example, when the gap G1 between the pole pieces 20a, 20b and the gap G2 between the pole pieces 24a, 24b are both 380 mm, each of the 160mm DSV magnetic field uniformity spaces F1, F2 has a center magnetic field strength of 0.2237 T.

According to the magnetic field generator 10a, elimination of the supporting yoke 26 results in lighter weight accordingly. In the present embodiment, the weight is 6552 kg, which is 1710 kg lighter than the magnetic field generator 10. Removal of the supporting yoke 26 has another advantage of reduced psychological pressure on the examinee.

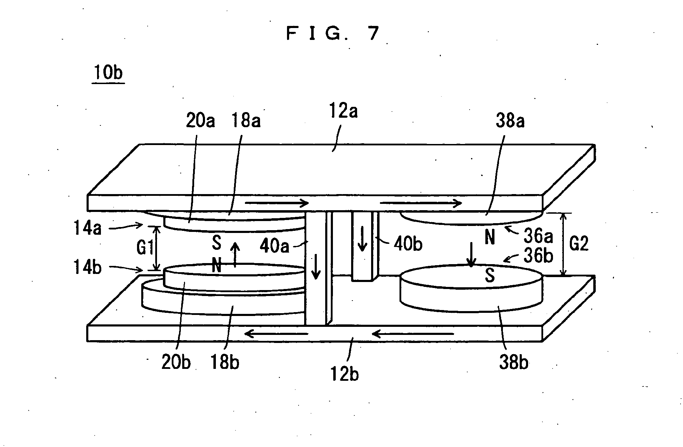

Next, reference will be made to Fig. 7 to describe a another magnetic field generator 10b.

In the magnetic field generator 10b, one pair of the magnetic poles 14a, 14b is constructed just the same as in the previous embodiment. However, the other pair of the magnetic poles 36a, 36b is constructed without permanent magnet groups, with pole pieces 38a, 38b. Further, the plate yokes 12a, 12b are connected with each other by two rectangular columns of supporting yokes 40a, 40b and magnetically connected with each other.

According to the magnetic field generator 10b, a magnetic circuit as indicated by the arrows is formed, and it is possible to supply part of magnetic flux generated by the magnetic poles 14a, 14b to the other magnetic poles 36a, 36b. With this arrangement, by adjusting the area of cross section of the central supporting yokes 40a, 40b, it is possible to adjust the strength of the magnetic field generated in the gap between the magnetic poles 36a, 36b.

For example, when the gap G1 between the pole pieces 20a, 20b and the gap G2 between the pole pieces 38a, 38b are both 380 mm, the 160mm DSV magnetic field uniformity space F1 (formed between the pole pieces 20a, 20b) has a center magnetic field strength of 0.1896 T whereas the 160mm DSV magnetic field uniformity space F2 (formed between the pole pieces 38a, 38b) has a center magnetic field strength of 0.0391 T.

Since the magnetic poles 36a, 36b do not use permanent magnet groups, a total amount of magnets used in the construction can be reduced and the magnetic field generator 10b can be lighter accordingly.

In Fig. 7, the other pair of magnetic poles 36a, 36b are constructed with the pole pieces 38a, 38b. Alternatively, the plate yokes 12a, 12b may be integrally formed with projections at predetermined places therein, to serve as the magnetic poles 36a, 36b.

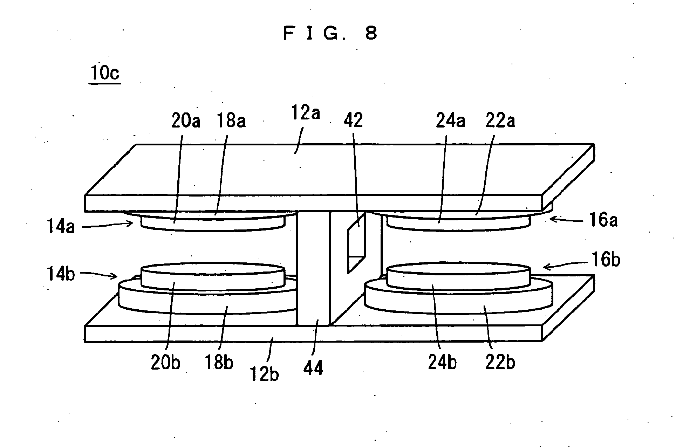

Further, as in a magnetic field generator 10c shown in Fig. 8, the supporting yoke may be provided by a supporting yoke 44 which is a pillar-like structure having a through hole 42. According to the magnetic field generator 10c, the fixed table may be disposed, for example, through the through hole 42, so that the test subject can be moved back and forth on the fixed table when taking MRI and ESR images.

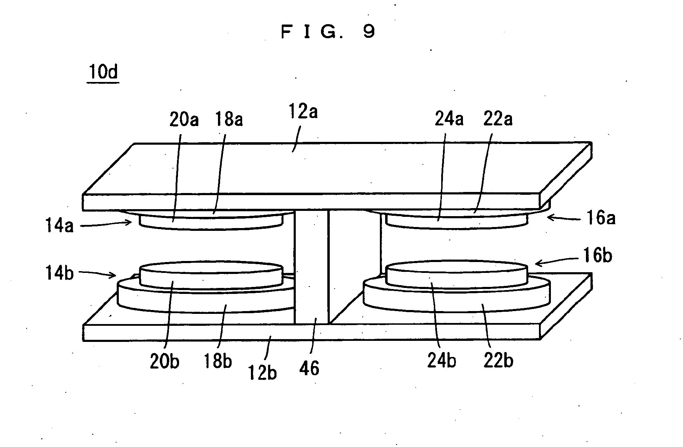

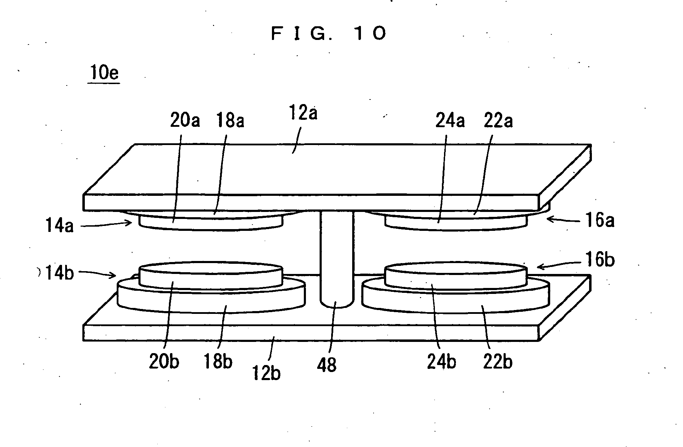

Further, as in a magnetic field generator 10d shown in Fig. 9, the supporting yoke may be provided by a supporting yoke 46 which is a pillar-like structure, or as in a magnetic field generator 10e shown in Fig. 10, the supporting yoke may be provided by a supporting yoke 48 which is a cylindrical column.

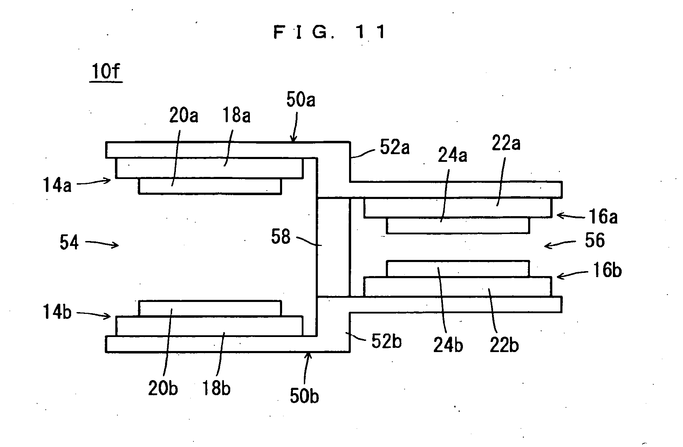

Further, reference will be made to Fig. 11 to describe a magnetic field generator 10f as another embodiment.

The magnetic field generator 10f includes a pair of plate yokes 50a, 50b. The plate yokes 50a, 50b have stepped regions 52a, 52b respectively, so when the plate yokes 50a and 50b are faced to each other, a large gap 54 and a small gap 56 are formed.

The large gap 54 and the small gap 56 are provided with a pair of magnetic poles 14a, 14b and a pair of magnetic poles 16a, 16b respectively, as in the previous embodiments. The plate yokes 50a, 50b have stepped regions 52a, 52b respectively, between which a supporting yoke 58 is attached.

The pair of magnetic poles 16a, 16b which is provided in small gap 56 of the magnetic field generator 10f is effective when the magnetic field uniformity space may be relatively small but the magnetic field strength must be high.

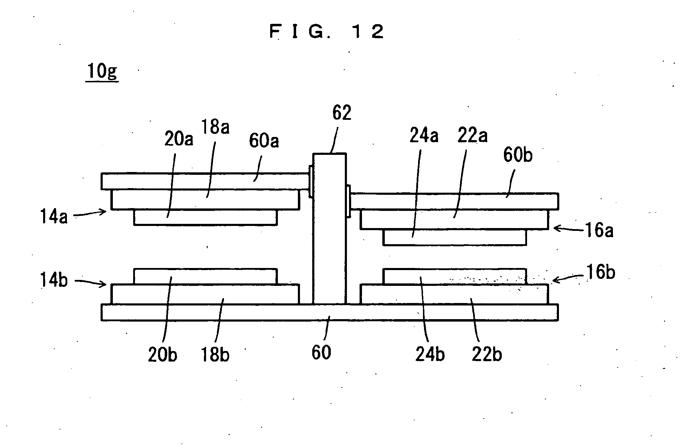

Next, reference will be made to Fig. 12 to describe a magnetic field generator 10g as another embodiment.

In the magnetic field generator 10g, the gap in each pair of opposed magnetic poles is variable.

The magnetic field generator 10g includes a plate yoke 60, and plate yokes 60a and 60b which are faced to the plate yoke 60. A supporting yoke 62 is erected at a generally center region of the plate yoke 60. The plate yokes 60a, 60b are attached to the supporting yoke 62 so that they can slide in vertical directions (toward and away from the plate yoke 60). As in the previous embodiments, the pair of magnetic poles 14a, 14b are provided between the plate yokes 60, 60a. As in the previous embodiments, the pair of magnetic poles 16a, 16b are provided between the plate yokes 60, 60b.

According to the magnetic field generator 10g, it is possible to adjust the size of magnetic field uniformity space, the magnetic field strength and the magnetic field uniformity by adjusting the gap between the magnetic poles 14a, 14b and the gap between the magnetic poles 16a, 16b.

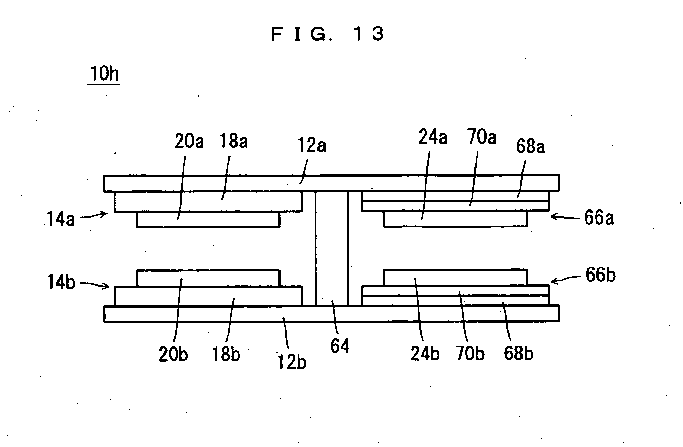

Next, reference will be made to Fig. 13 to describe a magnetic field generator 10h according to the invention.

The magnetic field generator 10h allows padding of the permanent magnet groups so that the gap can be constant.

In the magnetic field generator 10h, the pair of plate yokes 12a, 12b are magnetically connected with each other by a supporting yoke 64. In Fig. 13, a pair of magnetic poles 66a, 66b which are provided on the right hand side of the supporting yoke 64 include padding members 68a, 68b respectively. The padding members 68a, 68b are magnetic members, and are provided on the mutually opposed surfaces of the plate yokes 12a, 12b respectively. Relatively thin permanent magnet groups 70a, 70b made of rare-earth magnets etc. are formed on the padding members 68a, 68b respectively. Further, pole pieces 24a, 24b are provided on mutually opposed surfaces of the thin permanent magnet groups.

According to the magnetic field generator 10h, it is possible to make the gap between the pole pieces 20a, 20b and the gap between the pole pieces 24a, 24b dimensionally the same, and under this state to make the magnetic fields generated between these gaps have different magnetic field strengths from each other, even if the pair of magnetic poles 14a, 14b include the permanent magnet groups 18a, 18b which are made of rare-earth magnets, and the pair of magnetic poles 66a, 66b include the permanent magnet groups 70a, 70b which are made of rare-earth magnets. Specifically, according to the construction in Fig. 13, the magnetic field strength in the gap between the pole pieces 20a, 20b is higher than the magnetic field strength between the pole pieces 24a, 24b.

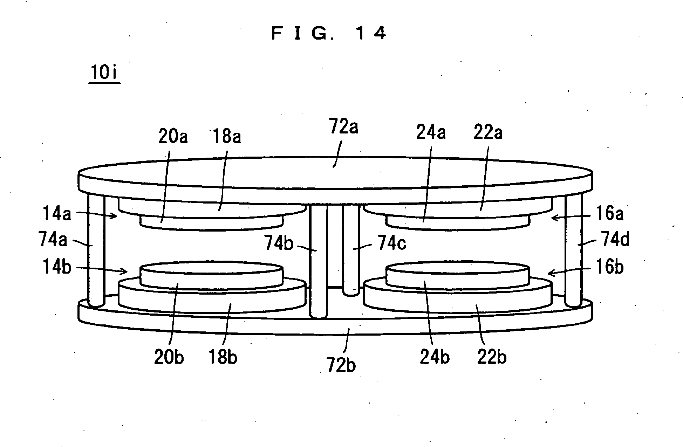

Further, Fig. 14 shows another magnetic field generator 10i.

The magnetic field generator 10i includes a pair of generally oval plate yokes 72a, 72b, and the plate yokes 72a, 72b are magnetically connected by four cylindrical columns of supporting yokes 74a through 74d.

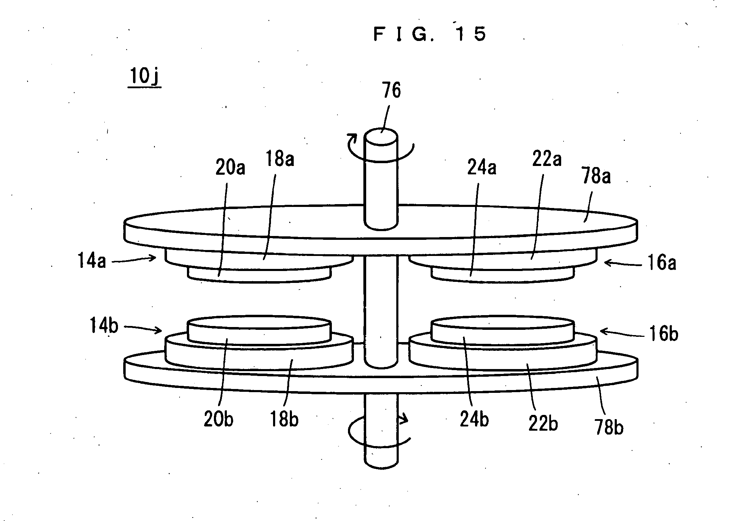

Fig. 15 shows another magnetic field generator 10j.

The magnetic field generator 10 includes a rotatable supporting yoke 76. The supporting yoke 76 is inserted through a pair of plate yokes 78a, 78b which are faced to each other. The plate yokes 78a, 78b are rotatable around the supporting yoke 76.

For example, assume that the pair of magnetic poles 14a, 14b are for MRI image taking, and the pair of magnetic poles 16a, 16b are for ESR image taking. First, the test subject is placed between the magnetic poles 14a, 14b, and MRI images are taken. Then, the plate yokes 78a, 78b are rotated by 180 degrees around the supporting yoke 76 to bring the test subject between the pair of magnetic poles 16a, 16b, where ESR images are taken. Thus, MRI and ESR images can be taken without moving the test subject but by rotating the plate yokes 78a, 78b around the supporting yoke 76.

It should be noted here that the magnetic field generator 10 shown in Fig. 1 may be constructed so that the magnetic field generated between the pair of magnetic poles 14a, 14b and the magnetic field generated between the pair of magnetic poles 16a, 16b have opposing directions from each other.

The magnetic field generator 10b shown in Fig. 7 may be constructed so that the magnetic field generated between the pair of magnetic poles 14a, 14b and the magnetic field generated between the pair of magnetic poles 36a, 36b have the same direction.

The magnetic field generators 10c through 10j shown in Fig. 8 through Fig. 15 each include two pairs of magnetic poles. The magnetic field generated between one pair of magnetic poles and the magnetic field generated between the other pair of magnetic poles may have the same or reverse direction.

Any of the magnetic field generators described above is applicable not only to an apparatus which serves as both of an MRI apparatus and an ESR imaging apparatus but also to an apparatus which allows MRI image taking at two locations, or to an apparatus which allows ESR image taking at two locations

The present invention is also applicable to a magnetic field generator which has three or more magnetic field uniformity spaces.

In any of the constructions described above, if the distance between the adjacent magnetic field uniformity spaces is too short, quality of image can be reduced by interference between noises due to signals etc. generated in the spaces when the examinee is being diagnosed. Therefore, it is preferable that electromagnetic shielding means such as a grounded Cu plate and Cu net is provided between the spaces.

By providing the shielding means, it becomes possible to prevent quality deterioration of the images, to shorten the distance between adjacent magnetic field uniformity spaces and to reduce the size of the entire apparatus.

The present invention being thus far described and illustrated in detail, it is obvious that these description and drawings only exemplify the present invention, and should not be interpreted as limiting the invention. The scope of the present invention is only limited by words used in the accompanied claims.

## Claims

1. A permanent-magnet type magnetic field generator for medical MRI or ESR imaging comprising:
a pair of plate yokes (12a, 12b) faced to each other with a gap in between and magnetically connected with each other by a supporting yoke (64); and
a first (14a, 14b) and a second pair (66a, 66b) of magnetic poles being disposed adjacent to each other with a gap in between, each pair of poles being respectively located between the two plate yokes (12a, 12b),
wherein the magnetic poles of each pair of magnetic poles face each other,
wherein, between the magnetic poles of each pair of magnetic poles, respectively, one magnetic field uniformity space is formed, thereby forming two magnetic field uniformity spaces which are spatially separated from each other and which respectively have a magnetic field uniformity variation of not greater than 100ppm,
wherein one of the two pairs of magnetic poles (14a, 14b) includes a permanent magnet group provided by rare-earth magnets,
wherein the other pair of magnetic poles (66a, 66b) includes a padding member (68a) and a permanent magnet group provided by rare-earth magnets which are disposed on the main surface of the padding member (68a) and in which the padding member (68a) is provided on the surface of a plate yoke,
wherein a magnetic field in the gap between the one pair of magnetic poles (14a, 14b) is higher than a magnetic field in the gap between the other pair of magnetic poles (66a, 66b),
wherein the padding members (68a, 68b) are magnetic, and
wherein each plate yoke magnetically couples two magnetic poles belonging to different pairs of magnetic poles, respectively, such that the magnetic field directions of the two magnetic field uniformity spaces are comprised in a magnetic circuit which is formed by the pair of plate yokes (12a, 12b), the supporting yoke (64) and the first and second pair of magnetic poles (14a, 14b, 66a, 66b).

2. The magnetic field generator according to claim 1, wherein the magnetic pole includes a pole piece.

3. The magnetic field generator according to claims 1 or 2, wherein at least part of one yoke of the pair of plate yokes is movable toward and away from the other plate yoke.

4. The magnetic field generator according to one of claims 1 through 3, wherein two magnetic field uniformity spaces which are adjacent to each other have different magnetic field strengths from each other.

5. The magnetic field generator according to one of claims 1 through 4, wherein electromagnetic shielding means is provided between two magnetic field uniformity spaces which are adjacent to each other.

## Patentansprüche

1. Ein Magnetfeldgenerator von einem Permanentmagnettyp für medizinische Magnetresonanztomographie- oder Elektronenspinresonanz-Bildgebung, der Magnetfeldgenerator aufweisend:
ein Plattenjochpaar (12a, 12b), wobei die Plattenjoche einander zugewendet sind mit einem dazwischenliegenden Freiraum und miteinander magnetisch verkoppelt sind mittels eines Stützjoches (64); und
ein erstes Magnetpolpaar (14a, 14b) und ein zweites Magnetpolpaar (66a, 66b), die nebeneinander angeordnet sind mit einem dazwischenliegenden Freiraum, wobei jedes Magnetpolpaar entsprechend zwischen den zwei Plattenjochen (12a, 12b) angeordnet ist,
wobei die Magnetpole jedes Magnetpolpaares einander zugewendet sind,
wobei zwischen den Magnetpolen jedes Magnetpolpaares jeweils ein Magnetfeld-Gleichmäßigkeitsraumbereich gebildet ist, wodurch zwei Magnetfeld-Gleichmäßigkeitsraumbereiche gebildet sind, welche voneinander räumlich getrennt sind und welche jeweils eine Magnetfeld-Gleichmäßigkeitsvariation von nicht größer als 100 ppm haben,
wobei eines der zwei Magnetpolpaare (14a, 14b) eine Permanentmagnetgruppe aufweist, welche von Seltenerdmagneten gebildet wird,
wobei das andere Magnetpolpaar (66a, 66b) ein Auflageelement (68a) und eine Permanentmagnetgruppe aufweist, welche durch Seltenerdmagneten gebildet wird, die auf der Hauptoberfläche des Auflageelements (68a) angeordnet sind, wobei das Auflageelement (68a) auf der Oberfläche eines Plattenjochs bereitgestellt ist,
wobei ein Magnetfeld in dem Freiraum zwischen dem einen Magnetpolpaar (14a, 14b) höher ist als ein Magnetfeld in dem Freiraum zwischen dem anderen Magnetpolpaar (66a, 66b),
wobei die Auflageelemente (68a, 68b) magnetisch sind, und
wobei jedes Plattenjoch jeweils zwei zu unterschiedlichen Magnetpolpaaren zugehörige Magnetpole magnetisch koppelt, so dass die Magnetfeldrichtungen der zwei Magnetfeld-Gleichmäßigkeitsraumbereiche in einem magnetischen Schaltkreis enthalten sind, welcher gebildet wird durch das Plattenjochpaar (12a, 12b), das Stützjoch (64) und das erste und das zweite Magnetpolpaar (14a, 14b, 66a, 66b).

2. Magnetfeldgenerator gemäß Anspruch 1, wobei der Magnetpol ein Polstück aufweist.

3. Magnetfeldgenerator gemäß Anspruch einem der Ansprüche 1 oder 2, wobei mindestens ein Teil eines der Joche des Plattenjochpaares in Richtung auf das andere Plattenjoch zu und von dem anderen Plattenjoch weg bewegbar ist.

4. Magnetfeldgenerator gemäß Anspruch 1 bis 3, wobei zwei Magnetfeld-Gleichmäßigkeitsraumbereiche, welche aneinander angrenzen, voneinander unterschiedliche Magnetfeldstärken haben.

5. Magnetfeldgenerator gemäß Anspruch 1 bis 4, wobei ein elektromagnetisches Abschirmmittel bereitgestellt ist zwischen zwei Magnetfeld-Gleichmäßigkeitsraumbereichen, welche aneinander angrenzen.

## Revendications

1. Générateur de champ magnétique du type à aimant permanent destiné à une imagerie RPE ou IRM médicale comprenant :
une paire de culasses du type plaque (12a, 12b) qui se font face l'une à l'autre séparées par un intervalle et connectées de manière magnétique l'une à l'autre par une culasse de support (64) ; et
des première (14a, 14b) et seconde (66a, 66b) paires de pôles magnétiques disposées adjacentes l'une à l'autre et séparées par un intervalle, chaque paire de pôles se situant respectivement entre les deux culasses du type plaque (12a, 12b) ;
dans lequel les pôles magnétiques de chaque paire de pôles magnétiques se font face les uns aux autres ;
dans lequel, entre les pôles magnétiques de chaque paire de pôles magnétiques, respectivement, un espace d'uniformité de champ magnétique est formé, en formant de ce fait deux espaces d'uniformité de champ magnétique qui sont séparés l'un de l'autre de manière spatiale et qui présentent respectivement une variation d'uniformité de champ magnétique qui est inférieure à 100 ppm ;
dans lequel l'une des deux paires de pôles magnétiques (14a, 14b) comprend un groupe d'aimants permanents constitué d'aimants en terres rares ;
dans lequel l'autre paire de pôles magnétiques (66a, 66b) comprend un élément de remplissage (68a) et un groupe d'aimants permanents constitué d'aimants en terres rares qui sont disposés sur la surface principale de l'élément de remplissage (68a) et dans lequel l'élément de remplissage (68a) est disposé sur la surface d'une culasse du type plaque ;
dans lequel le champ magnétique dans l'intervalle entre les pôles d'une paire de pôles magnétiques (14a, 14b) est plus élevé que le champ magnétique dans l'intervalle entre les pôles de l'autre paire de pôles magnétiques (66a, 66b) ;
dans lequel les éléments de remplissage (68a, 68b) sont magnétiques ; et
dans lequel chaque culasse du type plaque couple de manière magnétique deux pôles magnétiques qui appartiennent à différentes paires de pôles magnétiques, respectivement, de telle sorte que les directions de champ magnétique des deux espaces d'uniformité de champ magnétique soient comprises dans un circuit magnétique qui est constitué par la paire de culasses du type plaque (12a, 12b), la culasse de support (64) et les première et seconde paires de pôles magnétiques (14a, 14b, 66a, 66b).

2. Générateur de champ magnétique selon la revendication 1, dans lequel le pôle magnétique comprend une pièce polaire.

3. Générateur de champ magnétique selon la revendication 1 ou la revendication 2, dans lequel une partie au moins d'une culasse du type plaque de la paire de culasses du type plaque est mobile en allant vers l'autre culasse du type plaque et en s'éloignant de cette dernière.

4. Générateur de champ magnétique selon l'une quelconque des revendications 1 à 3, dans lequel les deux espaces d'uniformité de champ magnétique qui sont adjacents l'un à l'autre, présentent des intensités de champ magnétique qui diffèrent l'une de l'autre.

5. Générateur de champ magnétique selon l'une quelconque des revendications 1 à 4, dans lequel des moyens de blindage électromagnétique sont disposés entre les deux espaces d'uniformité de champ magnétique qui sont adjacents l'un à l'autre.
